# EUROPEAN PATENT APPLICATION

(11) **EP 2 866 272 A1**
(43) Date of publication of application: **29.04.2015**
(21) Application number: 14190150.4
(22) Date of filing: 23.10.2014
(51) Int. Cl.: H01L 41/187, C04B 35/462, C04B 35/495, H01L 41/316, H01L 41/317, H01L 41/318

(54) **Piezoelectric element, liquid ejecting head, liquid ejecting apparatus, actuator, sensor, and motor**

(30) Priority: 25.10.2013 JP 2013222790
(71) Applicant: Seiko Epson Corporation, Shinjuku-ku Tokyo (JP)
(72) Inventor: Hamada, Yasuaki, Suwa-shi, Nagano 392-8502 (JP)
(74) Representative: Miller Sturt Kenyon

(57) **Abstract**

A piezoelectric element to be used between a lowest use temperature T1 and a highest use temperature T2 includes a first electrode, a piezoelectric layer provided on the first electrode and made of a piezoelectric material including a composite oxide having a perovskite structure, and a second electrode provided on the piezoelectric layer, in which the piezoelectric material includes a morphotropic phase boundary which is inclined with respect to a temperature axis, and the piezoelectric material satisfies at least one of formulas T3≤T1≤T4 and T3≤T2≤T4, where a temperature corresponding to the morphotropic phase boundary is T3 at a lowest point, and is T4 at a highest point.

## Description

### BACKGROUND

### 1. Technical Field

The present invention relates to a piezoelectric element, a liquid ejecting head, and a liquid ejecting apparatus which are used in a piezoelectric element mounted onto other devices such as an actuator, ultrasonic devices like an ultrasonic oscillator and the like, an ultrasonic motor, a pressure sensor, a pyroelectric device such as an IR sensor, and the like.

### 2. Related Art

In a related art, a piezoelectric material used as a piezoelectric layer (piezoelectric ceramic) configuring a piezoelectric element and the like which are mounted on other devices such as an actuator, ultrasonic devices like an ultrasonic oscillator and the like, an ultrasonic motor, a pressure sensor, a pyroelectric device such as an IR sensor, and the like requires high piezoelectric properties, and lead zirconate titanate (PZT) is exemplified as a typical example.

However, a piezoelectric material in which lead content is suppressed is required in terms of environmental issues. As a lead-free piezoelectric material, a piezoelectric material containing alkali metal such as KₓNa₍₁₋ₓ₎NbO₃, (Ba, Na)TiO₃, and the like, and a piezoelectric material such as BiFeO₃-BaTiO₃ are exemplified.

As such a piezoelectric material, it is known that large piezoelectric properties are obtained by using a composition in the vicinity of a morphotropic phase boundary (MPB). However, in a phase diagram with a composition on a horizontal axis and temperature on a vertical axis, the PZT has a MPB line which is positioned substantially in parallel with a temperature axis, or is positioned perpendicularly to a composition axis; however, the lead-free piezoelectric material has MPB which is generally inclined with respect to the temperature axis (for example, refer to Fig. 1 and the like of JP-A-2009-215111). When the MBP line is inclined, even if a composition positioned on the MPB at a specified temperature, for example, a room temperature, is selected according to required characteristics, use environmental temperature changes cause a problem that there is a temperature region in which piezoelectric properties and a dielectric property of an element are lowered by being away from the MPB on a composition-temperature phase diagram due to a change in the use environmental temperature or heat generation during use.

### SUMMARY

An advantage of some aspects of the invention is to provide a piezoelectric element, a liquid ejecting head, and a liquid ejecting apparatus which can improve temperature dependence of piezoelectric properties.

According to an aspect of the invention, there is provided a piezoelectric element to be used between a lowest use temperature T1 and a highest use temperature T2, including a first electrode, a piezoelectric layer provided on the first electrode and made of a piezoelectric material including a composite oxide having a perovskite structure, and a second electrode provided on the piezoelectric layer, in which the piezoelectric material includes a morphotropic phase boundary that is inclined with respect to a temperature axis, and the piezoelectric material satisfies at least one of formulas T3≤T1≤T4 and T3≤T2≤T4, where a temperature corresponding to the morphotropic phase boundary is T3 at a lowest point, and is T4 at a highest point.

In this case, temperature dependence of piezoelectric properties in a use temperature range is reduced, thereby the piezoelectric element shows excellent piezoelectric properties in the use temperature range.

It is preferable that the piezoelectric material includes at least two types of composite oxides having a perovskite structure. In this case, the piezoelectric layer may be obtained by laminating a plurality of piezoelectric materials in which a ratio of constituent elements is different each other, or by distributing the plurality of piezoelectric materials in which the ratio of constituent elements is different each other in an in-plane direction. In this case, at least one of the formulas T3≤T1≤T4 and T3≤T2≤T4 can be satisfied by laminating the plurality of piezoelectric materials which have different mixing ratios of constituent elements, or by distributing the plurality of piezoelectric materials which have different ratios of constituent elements in an in-plane direction.

In addition, the piezoelectric layer may be obtained by laminating a plurality of piezoelectric materials in which at least one of two types or more of composite oxides is different each other, or by distributing the plurality of piezoelectric materials in which at least one of two types or more of composite oxides is different each other in an in-plane direction. In this case, at least one of the formulas T3≤T1≤T4 and T3≤T2≤T4 can be satisfied by laminating a plurality of piezoelectric materials in which at least one of two types or more of composite oxides is different, or distributing the plurality of piezoelectric materials in an in-plane direction.

It is preferable that, when the perovskite structure is expressed by ABO₃, A site include at least one of Pb, Ba, Sr, Ca, Li, K, Na, and Bi, and B site include at least one of Zr, Ti, Nb, Ta, Fe, Mn, and Co. In this case, temperature dependence of piezoelectric properties is more reliably reduced in the use temperature range, thereby the piezoelectric element shows excellent piezoelectric properties in the use temperature range.

It is preferable that the composite oxide include a combination of any of KNbO₃-NaNbO₃, KNb₃-KTaO₃, PbZrO₃-PbTi₃, (Bi_{1/2}K_{1/2})TiO₃-(Bi_{1/2}Na_{1/2})TiO₃, (Bi_{1/2}K_{1/2})TiO₃-BaTiO₃, (Bi_{1/2}NA_{1/2})TiO₃-BaTiO₃, BiFeO₃-BiCoO₃. In this case, temperature dependence of piezoelectric properties is more reliably reduced in the use temperature range, thereby the piezoelectric element shows excellent piezoelectric properties in the use temperature range.

It is preferable that the composite oxide may be be a mixed crystal of (K, Na)NbO₃ and Li(Nb, Ta)O₃. In this case, temperature dependence of piezoelectric properties is more reliably reduced in the use temperature range, thereby the piezoelectric element shows excellent piezoelectric properties in the use temperature range.

According to another aspect of the invention, there is provided a liquid ejecting head including the piezoelectric element.

In this case, a head in which temperature dependence of liquid ejecting properties is reduced can be realized.

According to still another aspect of the invention, there is provided a liquid ejecting apparatus including the liquid ejecting head.

In this case, an apparatus in which temperature dependence of the liquid ejecting properties is reduced can be realized.

According to another aspect of the invention, there is provided an actuator including the piezoelectric element.

In this case, an actuator in which temperature dependence is reduces can be realized.

According to another aspect of the invention, there is provided a sensor including the piezoelectric element.

In this case, a sensor in which temperature dependence is reduces can be realized.

According to another aspect of the invention, there is provided a motor including the piezoelectric element.

In this case, a motor in which temperature dependence is reduces can be realized.

### BRIEF DESCRIPTION OF THE DRAWINGS

Embodiments of the invention will now be described by way of example only with reference to the accompanying drawings, wherein like numbers reference like elements.
Fig. 1 is a diagram which shows an example of a phase diagram of a piezoelectric material of the present invention.
Fig. 2 is an exploded perspective view which shows a schematic configuration of a recording head according to Embodiment 1.
Fig. 3 is a plan view of a recording head according to Embodiment 1.
Fig. 4 is a cross-sectional view of the recording head according to Embodiment 1.
Fig. 5 is a diagram which shows a schematic configuration of a recording apparatus according to an embodiment of the invention.
Fig. 6 is a diagram which shows temperature dependence of a piezoelectric material used in Examples 1 to 26 of the invention.
Fig. 7 is a diagram which shows temperature dependence of piezoelectric properties of Examples 1 to 8 of the invention.
Fig. 8 is a diagram which shows temperature dependence of piezoelectric properties of Examples 9 to 18 of the invention.
Fig. 9 is a diagram which shows temperature dependence of piezoelectric properties of Examples 19 to 26 of the invention.
Fig. 10 is a diagram which shows temperature dependence of a piezoelectric material used in Examples 27 to 32 of the invention.
Fig. 11 is a diagram which shows temperature dependence of piezoelectric properties of Examples 27 to 29 of the invention.
Fig. 12 is a diagram which shows temperature dependence of piezoelectric properties of Examples 30 to 32 of the invention.

### DESCRIPTION OF EXEMPLARY EMBODIMENTS

Hereinafter, the invention will be described in detail based on embodiments.

Piezoelectric materials which configure a piezoelectric layer of a piezoelectric element of the invention are as follows.

### Piezoelectric Material

A piezoelectric material used in the invention includes a morphotropic phase boundary which is inclined to a temperature axis. That is, the piezoelectric material includes at least two types of components made of a composite oxide having a perovskite structure.

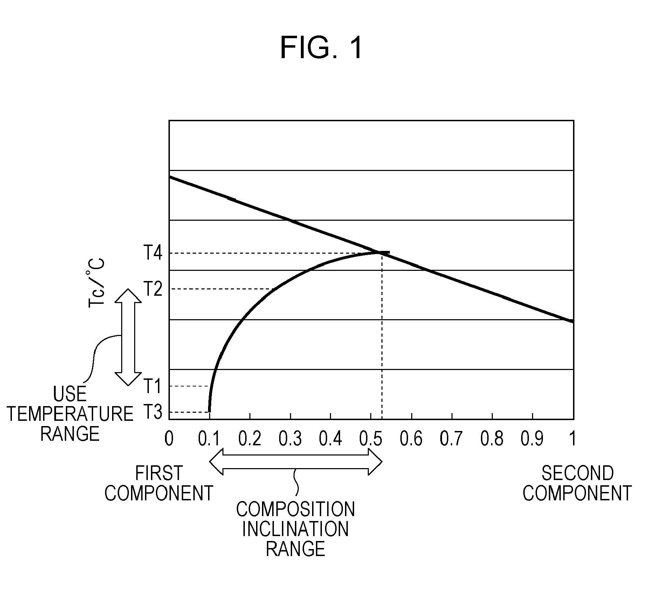

For example, an MPB line of a piezoelectric material, which contains a first component made of composite oxide that is a rhombohedral crystal in a single composition and has a perovskite structure and a second component made of composite oxide that is a crystal other than the rhombohedral crystal in a single composition and has a perovskite structure, in a phase diagram with a composition ratio of the first component to a sum of the first component and the second component (first component/(first component + second component)) on a horizontal axis, and temperature on a vertical axis is inclined with respect to a temperature axis. In a case of Fig. 1, a lowest temperature T3 of a temperature corresponding to a morphotropic phase boundary is a case when a composition ratio is approximately 0.1, and a highest temperature T4 is a case when a composition ratio is 0.53.

In the invention, when a lowest use temperature of the piezoelectric element is T1, and a highest use temperature is T2, that is, when a piezoelectric element is used at a temperature between the lowest use temperature T1 and the highest use temperature T2, at least one of formulas T3≤T1≤T4 and T3≤T2≤T4 is satisfied.

In order to form a piezoelectric layerwhich satisfies such a relationship, the piezoelectric material comprised of a single composition which is obtained by mixing two types of components described above at a predetermined ratio is rarely realized. Therefore, as shown in detail in examples, it is preferable to realize a piezoelectric layer which satisfies the relationships as a whole by laminating piezoelectric materials in which the ratio of constituent elements is different each other, i.e. the piezoelectric materials which have different compositions, or by distributing the piezoelectric materials which have different compositions in an in-plane direction. In addition, instead of using a plurality of piezoelectric materials having different compositions, different material systems may be combined.

In the invention, when a piezoelectric element is used at a temperature between the lowest use temperature T1 and the highest use temperature T2, temperature dependence of piezoelectric properties in a use temperature range is improved by satisfying at least one of formulas T3≤T1≤T4 and T3≤T2≤T4. This is because extreme lowering of the piezoelectric properties in T1 or T2 which is a boundary of the use temperature range is compensated by a component whose phase boundary temperature is extremely low or a component whose phase boundary temperature is extremely high.

In addition, it is preferable to satisfy at least a relationship of T3≤T1≤T4 in many cases. This is because the piezoelectric properties generally are more severely lowered at a low temperature side of the phase boundary temperature than at a high temperature side when having a phase boundary temperature at a temperature fully lower than a Curie temperature.

Moreover, it is preferable to satisfy both relationships of T3≤T1≤T4 and T3≤T2≤T4. This is because lowering of the piezoelectric properties is compensated in both boundaries (T1 and T2) of the use temperature range.

The above points will be described in detail while showing examples of a structure of a piezoelectric element and a liquid ejecting head.

### Piezoelectric Element, Liquid Ejecting Head

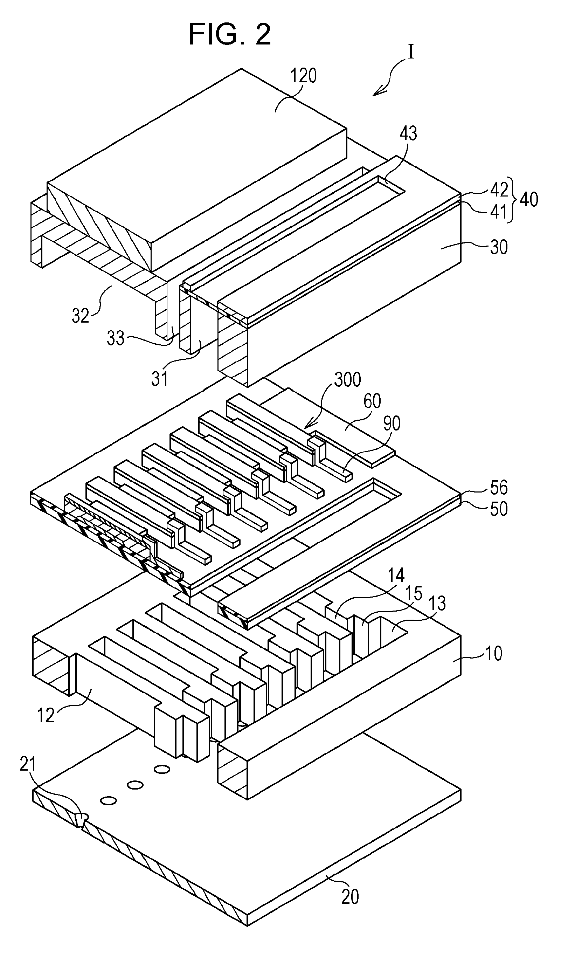

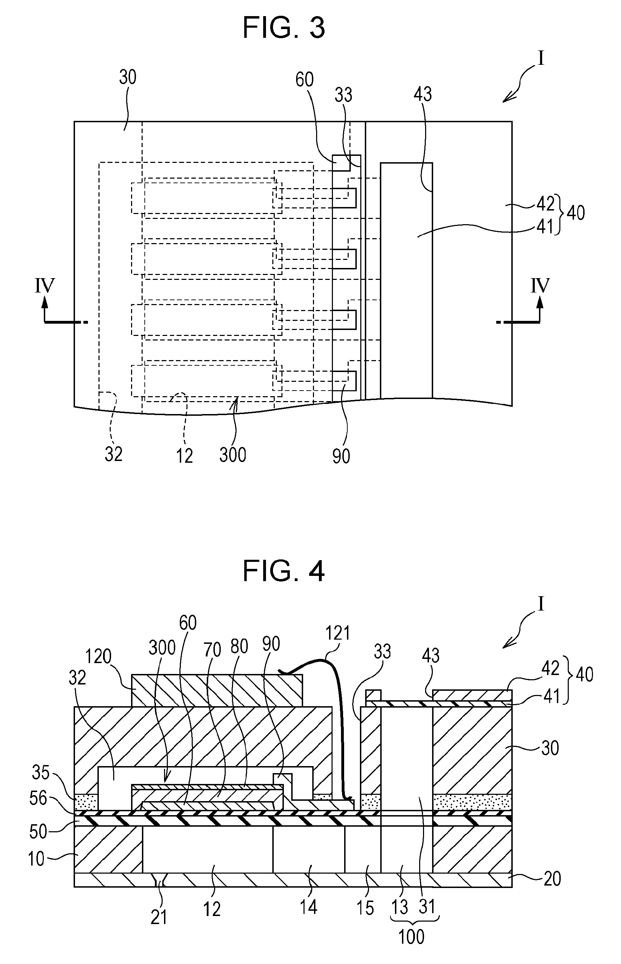

Fig. 2 is an exploded perspective view which shows a schematic configuration of an ink jet recording head which is an example of a liquid ejecting head including the piezoelectric element according to an embodiment of the invention, Fig. 3 is a plan view of Fig. 2, and Fig. 4 is a cross-sectional view taken along line IV-IV of Fig. 3. As shown in Figs. 2 to 4, a flow path forming substrate 10 of the embodiment is made of a silicon single crystal substrate, and an elastic film 50 made of silicon dioxide is formed on one surface of the flow path forming substrate.

A plurality of pressure generating chambers 12 are arrayed on the flow path forming substrate 10 in a width direction thereof. Moreover, a communication portion 13 is formed in an outside region of a longitudinal direction of the pressure generating chamber 12 of the flow path forming substrate 10, and the communication portion 13 and each pressure generating chamber 12 communicate with each other through an ink supply path 14 and a communication path 15 provided in each pressure generating chamber 12. The communication portion 13 communicates with a manifold portion 31 of a protective substrate to be described below to configure a portion of a manifold which is a common ink chamber of each pressure generating chamber 12. The ink supply path 14 is formed to be narrower in width than the pressure generating chamber 12, and constantly holds a flow path resistance of an ink flowing from the communication portion 13 to the pressure generating chamber 12. In the embodiment, the ink supply path 14 is formed by narrowing a width of a flow path from one side; however, the ink supply path may be formed by narrowing the width of the flow path from both sides. Moreover, the ink supply path may be formed by not narrowing the width of the flow path, but narrowing from a thickness direction. In the embodiment, a liquid flow path made of the pressure generating chamber 12, the communication portion 13, the ink supply path 14, and the communication path 15 is provided on the flow path forming substrate 10.

In addition, a nozzle plate 20 is fixed to an opening surface side of the flow path forming substrate 10 by an adhesive, a thermal welding film, or the like. The nozzle plate 20 has bored therein a nozzle opening 21 that communicates with a vicinity of an opposite side to the ink supply path 14 of each pressure generating chamber 12. The nozzle plate 20 is made of, for example, glass ceramics, a silicon single crystal substrate, stainless steel, or the like.

On the other hand, the elastic film 50 as described above is formed at an opposite side to the opening surface of the flow path forming substrate 10, and an adhesion layer 56 which is made of titanium oxide to improve adhesion of the elastic film 50 and the like to the ground of the first electrode 60 is provided on the elastic film 50. An insulating film made of zirconium oxide may be formed between the elastic film 50 and the adhesion layer 56 when necessary.

Furthermore, on the adhesion layer 56, the first electrode 60, a piezoelectric layer 70 which is a thin film whose thickness is 2 µm or less, preferably 0.3 µm to 1.5 µm, and a second electrode 80 are laminated to configure a piezoelectric element 300. Here, the piezoelectric element 300 refers to a portion which includes the first electrode 60, the piezoelectric layer 70, and the second electrode 80. In general, any one electrode of the piezoelectric elements 300 is set to be a common electrode, and thereby the other electrode and the piezoelectric layer 70 are configured to be patterned for each pressure generating chamber 12. In the embodiment, the first electrode 60 is set to be a common electrode of the piezoelectric element 300, and the second electrode 80 is set to be an individual electrode of the piezoelectric element 300; however, there is no problem to be reversed for convenience of a driving circuit or wiring. Moreover, here, a combination of the piezoelectric element 300 and an oscillation plate which is displaced by a driving of the piezoelectric element 300 is referred to as an actuator. In the example, the elastic film 50, the adhesion layer 56, the first electrode 60, and an insulating film provided when necessary function as an oscillation plate. However, the invention is not limited thereto, and need not include, for example, the elastic film 50 or the adhesion layer 56. Moreover, the piezoelectric element 300 itself may be set to substantially serve as the oscillation plate.

It is preferable that an A site include at least one type of Pb, Ba, Sr, Ca, Li, K, Na, and Bi, and a B site include at least one type of Zr, Ti, Nb, Ta, Fe, Mn, and Co when a piezoelectric material has a perovskite structure, and is represented by ABO₃. Moreover, it is preferable that a composite oxide which configures a piezoelectric layer include a combination of any of KNbO₃-NaNbO₃, KNb₃-KTaO₃, PbZrO₃-PbTi₃, (Bi_{1/2}K_{1/2})TiO₃-(Bi_{1/2}Na_{1/2})TiO₃, (Bi_{1/2}K_{1/2})TiO₃-BaTiO₃, (Bi_{1/2}Na_{1/2})TiO₃-BaTiO₃, and BiFeO₃-BiCoO₃.

In the embodiment, the piezoelectric layer 70 is made of the piezoelectric materials of the invention described above. When using such a piezoelectric material, it is possible to realize a piezoelectric element which shows excellent displacement properties at a use environmental temperature.

A lead electrode 90 which is drawn from near an end portion of the ink supply path 14 side, extends to the adhesion layer 56, and is made of, for example, gold (Au) and the like, is connected to each second electrode 80 which is an individual electrode of the piezoelectric element 300.

On the flow path forming substrate 10 on which such a piezoelectric element 300 is formed, that is, on the first electrode 60, the adhesion layer 56, and the lead electrode 90, a protective substrate 30 which has a manifold portion 31 configuring at least a portion of the manifold 100 is bonded via an adhesive 35. The manifold portion 31 penetrates the protective substrate 30 in the thickness direction to be formed over a width direction of the pressure generating chamber 12, and communicates with the communication portion 13 of the flow path forming substrate 10 as described above to configure the manifold 100 which is a common ink chamber of each pressure generating chamber 12. Moreover, the manifold portion 31 only may be a manifold by dividing the communication portion 13 of the flow path forming substrate 10 into multiple parts for each pressure generating chamber 12. Furthermore, for example, it is possible to provide only the pressure generating chamber 12 on the flow path forming substrate 10, and the ink supply path 14 which allows the manifold 100 and each pressure generating chamber 12 to communicate with each other may be provided in a member (for example, the elastic film 50, the adhesion layer 56, and the like) interposed between the flow path forming substrate 10 and the protective substrate 30.

In addition, a piezoelectric element holding unit 32 having such a space so as not to hinder an operation of the piezoelectric element 300 is provided in a region facing the piezoelectric element 300 of the protective substrate 30. When the piezoelectric element holding unit 32 has such a space so as not to hinder the operation of the piezoelectric element 300, the space may be sealed or may not be sealed.

As the protective substrate 30, it is preferable to use a material having substantially the same coefficient of thermal expansion as the flow path forming substrate 10, such as glass, ceramic material, and the like. In the embodiment, the protective substrate 30 is formed using a silicon single crystal substrate of the same material as the flow path forming substrate 10.

Moreover, a through hole 33 which penetrates the protective substrate 30 in a thickness direction is provided on the protective substrate 30. Then, a vicinity of an end portion of the lead electrode 90 drawn from each piezoelectric element 300 is provided so as to be exposed in the through hole 33.

Moreover, a driving circuit 120 for driving the arrayed piezoelectric element 300 is fixed on the protective substrate 30. As the driving circuit 120, for example, it is possible to use a circuit substrate, a semiconductor integrated circuit (IC), or the like. Then, the driving circuit 120 and the lead electrode 90 are electrically connected via a connecting wire 121 made of a conductive wire such as a bonding wire and the like.

In addition, a compliance substrate 40 made of a sealing film 41 and a fixing plate 42 is bonded on the protective substrate 30. Here, the sealing film 41 is made of a flexible material having low rigidity, and one side of the manifold portion 31 is sealed by the sealing film 41. Moreover, the fixing plate 42 is formed of relatively hard material. Since a region of the fixing plate 42 facing the manifold 100 is the opening 43 completely removed in a thickness direction, the one side of the manifold 100 is sealed only by the sealing film 41 having flexibility.

In such an ink jet recording head I of the embodiment, an ink is taken from an ink inlet connected to an external ink supply unit which is not illustrated, an inside of the ink jet recording head is filled with an ink until the ink jet recording head reaches a nozzle opening 21 from the manifold 100, a voltage is applied between each first electrode 60 and each second electrode 80 which correspond to the pressure generating chamber 12 according to a recording signal from the driving circuit 120, and the elastic film 50, the adhesion layer 56, the first electrode 60, and the piezoelectric layer 70 are flexurally deformed, and thereby a pressure in each pressure generating chamber 12 increases and an ink droplet is discharged from the nozzle opening 21.

Next, a method of manufacturing the piezoelectric element of the ink jet recording head of the embodiment will be described.

First, a silicon dioxide film which is made of silicon dioxide (SiO₂) and the like configuring the elastic film 50 is formed on a surface of a flow path forming a substrate wafer that is a silicon wafer by thermal oxidation and the like. Next, the adhesion layer 56 which is made of titanium oxide and the like is formed on the elastic film 50 (silicon dioxide film) by reactive sputtering, thermal oxidation, or the like.

Next, the first electrode 60 is formed on the adhesion layer 56. Specifically, the first electrode 60 which is made of platinum, iridium, iridium oxide, a laminated structure of these, or the like is formed on the adhesion layer 56. The adhesion layer 56 and the first electrode 60 can be formed by, for example, a sputtering method or a deposition method.

Next, the piezoelectric layer 70 is laminated on the first electrode 60. A method of manufacturing the piezoelectric layer 70 is not particularly limited; however, the piezoelectric layer 70 can be formed by using a chemical solution method such as a Metal-Organic Decomposition (MOD) method, a sol-gel method or the like in which the piezoelectric layer 70 that is made of metal oxides is obtained by applying and drying a solution which dissolves and disperses organometallic compounds in a solvent and baking the solution at a high temperature. The piezoelectric layer 70 may be formed by other methods such as a laser ablation method, a sputtering method, a pulsed laser deposition (PLD) method, a CVD method, an aerosol deposition method, and the like.

When forming the piezoelectric layer 70 by, for example, a chemical coating method, as a starting material, 2-ethylhexanoate salt, acetate, and the like which include a desired element are used. For example, 2-ethylhexanoic acid bismuth, 2-ethylhexanoic acid barium, 2-ethyl hexane iron, 2-ethylhexanoic acid titanium, and the like are used. A precursor solution is made by mixing each n-octane solution and adjusting a molar ratio of a metal element so as to be in accordance with a stoichiometric ratio. Next, a piezoelectric film is formed by a spin coating method of dropping the precursor solution on a lower electrode which is previously made and rotating this at 500 rpm for six seconds, and then rotating a substrate at 3000 rpm for 20 seconds. Next, the substrate is placed on a hot plate, and dried at 180°C for two minutes. Then, the substrate is placed on the hot plate, and degreasing is performed at 350°C for two minutes. After carrying out the solution coating to degreasing processes twice, baking is performed at 750°c for five minutes using an RTA device in an oxygen atmosphere. Then, it is possible to form the piezoelectric layer 70 by carrying out the above-mentioned processes five times (thus, coating ten times) in total.

After forming the piezoelectric layer 70 in this manner, the second electrode 80 which is made of platinum and the like is formed on the piezoelectric layer 70 by a sputtering method and the like, and the piezoelectric layer 70 and the second electrode 80 are patterned at the same time in a region facing each pressure generating chamber 12, thereby forming the piezoelectric element 300 which is made of the first electrode 60, the piezoelectric layer 70, and the second electrode 80. In the patterning of the piezoelectric layer 70 and the second electrode 80, it is possible to collectively perform dry etching via a resist (not illustrated) which is formed in a predetermined shape. Thereafter, post annealing may be performed in a temperature range from 600°C to 800°C when necessary. Accordingly, it is possible to form a good interface between the piezoelectric layer 70 and the first electrode 60 or the second electrode 80, and to improve crystallinity of the piezoelectric layer 70.

Next, the lead electrode 90 which is made of, for example, gold (Au) and the like is formed over an entire surface of the flow path forming substrate wafer, and then each piezoelectric element 300 is patterned via a mask pattern made of, for example, a resist and the like.

Next, a protective substrate wafer which is a silicon wafer and made of a plurality of protective substrates 30 is bonded to a piezoelectric element 300 side of the flow path forming substrate wafer via the adhesive 35, and then the flow path forming substrate wafer is thinned to a predetermined thickness.

Next, a mask film is newly formed on the flow path forming substrate wafer and is patterned in a predetermined shape.

Then, the pressure generating chamber 12 corresponding to the piezoelectric element 300, the communication portion 13, the ink supply path 14, the communication path 15, and the like are formed by performing anisotropic etching (wet etching) using an alkaline solution such as KOH and the like through the mask film on the flow path forming substrate wafer.

Thereafter, an unnecessary portion of an outer peripheral edge portion of the flow path forming substrate wafer and the protective substrate wafer is removed, for example, by cutting using dicing and the like. Then, the ink jet recording head I of the embodiment is realized by removing a mask film of the flow path forming substrate wafer which is on an opposite surface to the protective substrate wafer, bonding the nozzle plate 20 on which the nozzle opening 21 is bored, bonding the compliance substrate 40 to the protective substrate wafer, and dividing the flow path forming substrate wafer into the flow path forming substrate 10 of one chip size as shown in Fig. 2 and the like.

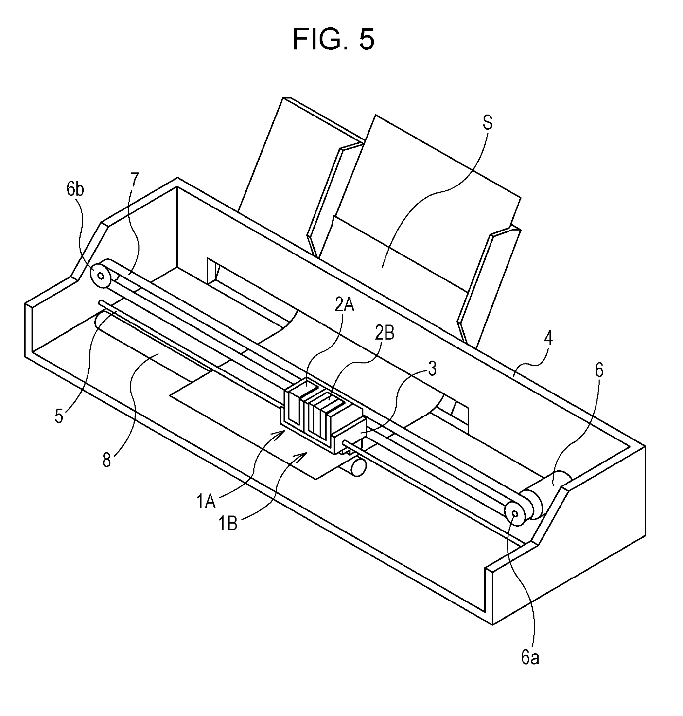

In addition, the ink jet recording head in these embodiments configures a portion of a recording head unit which includes an ink flow path communicating with an ink cartridge and the like, and is mounted on an inkjet recording apparatus. Fig. 5 is a schematic diagram which shows an example of the ink jet recording apparatus.

As shown in Fig. 5, recording head units 1A and 1B having the ink jet recording head I are equipped with cartridges 2A and 2B which configure an ink supply unit in a detachable manner, and a carriage 3 mounted with the recording head units 1A and 1B is provided at a carriage axis 5 attached to the apparatus main body 4 in a movable manner in an axis direction. The recording head units 1A and 1B discharge, for example, each of a black ink composition and a color ink composition.

Then, a driving force of a driving motor 6 is transmitted to the carriage 3 via a plurality of gears (not illustrated) and a timing belt 7, and thereby the carriage 3 mounted with the recording head units 1A and 1B is moved along the carriage axis 5. On the other hand, a transport roller 8 is provided as a transport unit in the apparatus main body 4, and a recording sheet S which is a recording medium such as paper and the like is made to be transported by a transport roller 8. A transport unit which transports the recording sheet S is not limited to the transport roller, and may be a belt, a drum, or the like.

In an example shown in Fig. 5, the ink jet recording head units 1A and 1B include one ink jet recording head I, respectively; however, are not particularly limited thereto. For example, the one ink jet recording head unit 1A or 1B may be set to have two or more ink jet recording heads. Examples 1 to 18

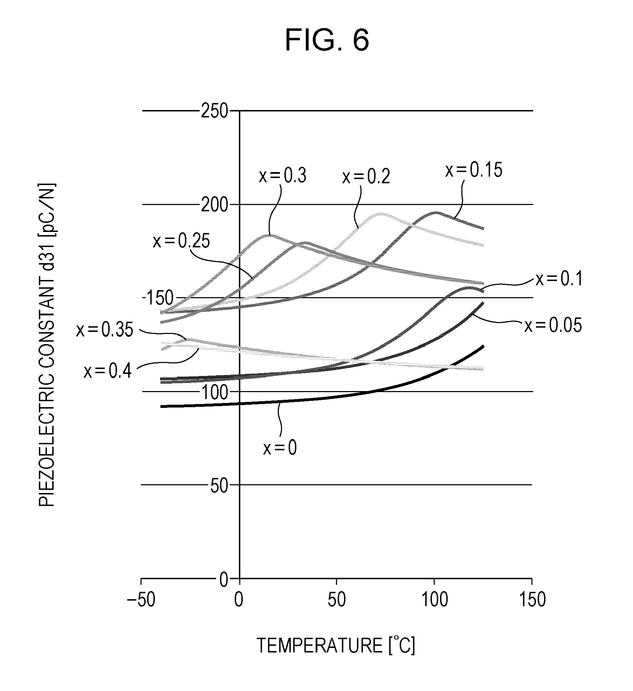

As a piezoelectric material, piezoelectric materials (K_{0.47}Na_{0.47}Li_{0.04})(Nb₁₋ₓTaₓ)O₃ expressed as a mixed crystal between (K, Na)NbO₃ and Li(Nb, Ta)O₃ are used. This material has tetragonal-orthorhombic phase boundaries, a morphotropic phase boundary (MPB) in a phase diagram with a composition on a horizontal axis and a temperature on a vertical axis is inclined with respect to a temperature axis, a MPB temperature is changed by x, and temperature dependence of a piezoelectric constant in each x composition is as shown in Fig. 6.

In order to use the present material system in a temperature range from -40°C (lowest use temperature T1) to 125°C (highest use temperature T2), materials of each composition with x=0.15, 0.2, 0.25, 0.3, and 0.4 are laminated at a thickness ratio in Table 1 to form a piezoelectric layer of Examples 1 to 18.

In Examples 1 to 18, if layers of each composition are laminated so that a ratio in a thickness of each composition becomes a ratio in Table 1, even if each composition is set to be one layer, or set to be divided into a plurality of layers, separated through other compositions, and laminated, there is the same temperature dependence of piezoelectric properties if a sum of thicknesses of these layers is a ratio in Table 1.

Moreover, a composition having a minimum temperature variation among single compositions is regarded as a piezoelectric element in Comparative Example 1, and a composition having maximum piezoelectric properties among single compositions is regarded as a piezoelectric element in Comparative Example 2.

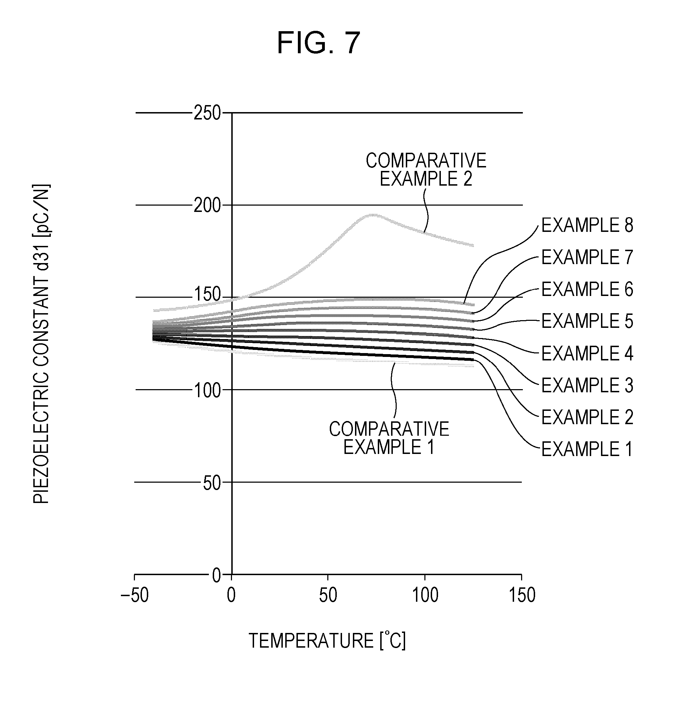

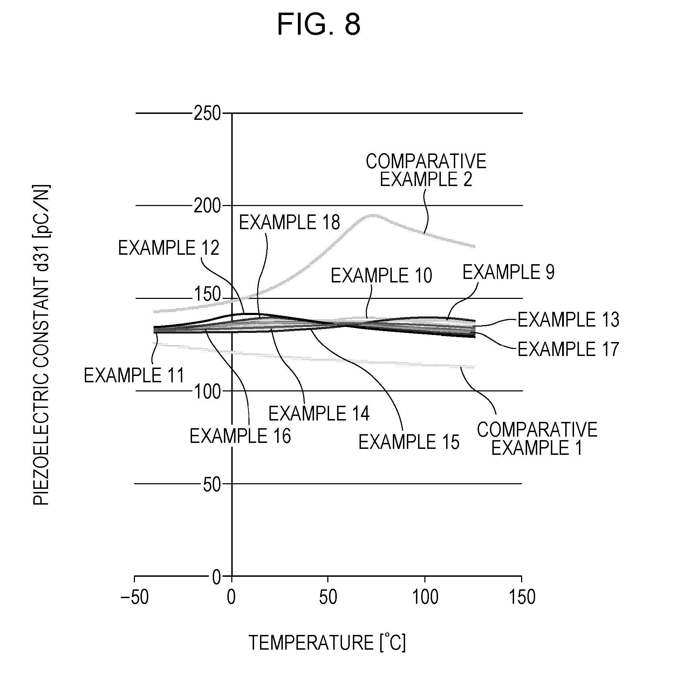

A lowest temperature T3 and a highest temperature T4 of an MPB line in each of Examples 1 to 18, a maximum value and a minimum value in the use temperature range of the piezoelectric constant d31, and a variation range are shown in Table 1, and temperature dependence of the piezoelectric constant d31 is shown in Figs. 7 and 8.

As shown in Table 1, the piezoelectric element of Examples 1 to 18 satisfies a relationship of T3≤T1≤T4, but does not satisfy a relationship of T3≤T2≤T4. Comparative Example 1 does not satisfy the relationship of either T1≤T4 or T3≤T2≤T4. Comparative Example 2 does not satisfy relationships of either T3≤T1≤T4 or T3≤T2≤T4. Neither Comparative Example 1 nor Comparative Example 2 has a morphotropic phase boundary which is inclined with respect to a temperature axis.

As shown in Figs. 7 and 8, piezoelectric properties in the use temperature range from-40°C to 125°C in each embodiment are larger than in Comparative Example 1, and furthermore, temperature variation is smaller than in Comparative Example 2, and thereby effects of the invention are proved.

**Table 1**

| COMPOSITION | x=0.15 | x=0.2 | x=0.25 | x=0.3 | x=0.4 | T3(°C) | T4(°C) | PIEZOELECTRIC CONSTANT d31[PC/N] | | |
|---|---|---|---|---|---|---|---|---|---|---|
| MPB | 102 | 74 | 34.5 | 17 | -59 | | | Max | Min | Range |
| EXAMPLE 1 | 0.02 | 0.02 | 0.02 | 0.02 | 0.92 | -59 | 102 | 128 | 117 | 9% |
| EXAMPLE 2 | 0.04 | 0.04 | 0.04 | 0.04 | 0.84 | -59 | 102 | 129 | 121 | 7% |
| EXAMPLE 3 | 0.06 | 0.06 | 0.06 | 0.06 | 0.76 | -59 | 102 | 131 | 125 | 5% |
| EXAMPLE 4 | 0.08 | 0.08 | 0.08 | 0.08 | 0.68 | -59 | 102 | 133 | 129 | 3% |
| EXAMPLE 5 | 0.1 | 0.1 | 0.1 | 0.1 | 0.6 | -59 | 102 | 136 | 133 | 2% |
| EXAMPLE 6 | 0.12 | 0.12 | 0.12 | 0.12 | 0.52 | -59 | 102 | 141 | 135 | 4% |
| EXAMPLE 7 | 0.14 | 0.14 | 0.14 | 0.14 | 0.44 | -59 | 102 | 145 | 136 | 7% |
| EXAMPLE 8 | 0.16 | 0.16 | 0.16 | 0.16 | 0.36 | -59 | 102 | 150 | 137 | 9% |
| EXAMPLE 9 | 0.4 | 0 | 0 | 0 | 0.6 | -59 | 102 | 140 | 132 | 5% |
| EXAMPLE 10 | 0 | 0.4 | 0 | 0 | 0.6 | -59 | 74 | 140 | 133 | 5% |
| EXAMPLE 11 | 0 | 0 | 0.4 | 0 | 0.6 | -59 | 34.5 | 138 | 129 | 6% |
| EXAMPLE 12 | 0 | 0 | 0 | 0.4 | 0.6 | -59 | 17 | 142 | 130 | 8% |
| EXAMPLE 13 | 0.2 | 0.2 | 0 | 0 | 0.6 | -59 | 102 | 139 | 133 | 4% |
| EXAMPLE 14 | 0.2 | 0 | 0.2 | 0 | 0.6 | -59 | 102 | 136 | 133 | 2% |
| EXAMPLE 15 | 0.2 | 0 | 0 | 0.2 | 0.6 | -59 | 102 | 137 | 134 | 2% |
| EXAMPLE 16 | 0 | 0.2 | 0.2 | 0 | 0.6 | -59 | 74 | 137 | 132 | 4% |
| EXAMPLE 17 | 0 | 0.2 | 0 | 0.2 | 0.6 | -59 | 74 | 137 | 132 | 4% |
| EXAMPLE 18 | 0 | 0 | 0.2 | 0.2 | 0.6 | -59 | 34.5 | 139 | 130 | 7% |
| COMPARATIVE EXAMPLE 1 | 0 | 0 | 0 | 0 | 1 | -59 | -59 | 126 | 113 | 10% |
| COMPARATIVE EXAMPLE 2 | 0 | 1 | 0 | 0 | 0 | 74 | 74 | 195 | 143 | 27% |

### Examples 19-26

In Examples 19 to 26, a piezoelectric element is formed by having a piezoelectric material in each composition which is used in Examples 1 to 18 at a ratio shown in Table 2 in a surface of a piezoelectric layer. In this case, a component of each composition may be in a single unit, or one composition may be separated into a plurality of units and a sum of these areas may be set to be a ratio of Table 2. Both cases are the same in terms of temperature dependence of piezoelectric properties.

Moreover, a composition having a minimum temperature variation among single compositions is regarded as a piezoelectric element in Comparative Example 1, and a composition having maximum piezoelectric properties among single compositions is regarded as a piezoelectric element in Comparative Example 2.

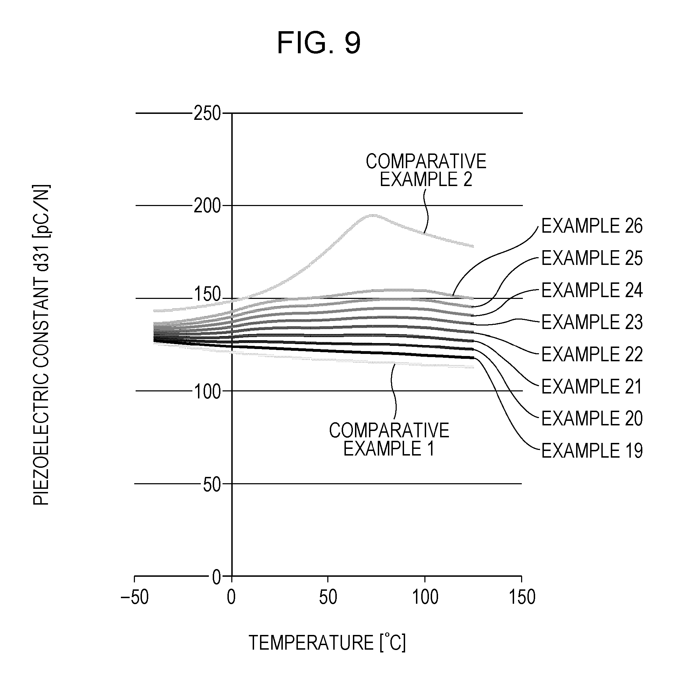

A minimum temperature T3 and a maximum temperature T4 of an MPB line in each of Examples 19 to 26, a maximum value and a minimum value in the use temperature range of the piezoelectric constant d31, and a variation range are shown in Table 2, and temperature dependence of the piezoelectric constant d31 is shown in Fig. 9.

As shown in Table 2, a piezoelectric element in Examples 19 to 26 satisfies a relationship of T3≤T1≤T4, but does not satisfy a relationship of T3≤T2≤T4. Comparative Example 1 does not satisfy the relationship of either T1≤T4 or T3≤T2≤T4. Comparative Example 2 does not satisfy relationships of either T3≤T1≤T4 or T3≤T2≤T4. Neither Comparative Example 1 nor 2 has a morphotropic phase boundary which is inclined with respect to a temperature axis.

As shown in Fig. 9, piezoelectric properties in the use temperature range from -40°C to 125°C in each embodiment are larger than in Comparative Example 1, and furthermore, temperature variation is smaller than in Comparative Example 2, and thereby effects of the invention are proved.

**Table 2**

| COMPOSITION | x=0.15 | x=0.2 | x=0.25 | x=0.3 | x=0.4 | T3(°C) | T4(°C) | PIEZOELECTRIC CONSTANT d31[pC/N] | | |
|---|---|---|---|---|---|---|---|---|---|---|
| MPB | 102 | 74 | 34.5 | 17 | -59 | | | Max | Min | Range |
| EXAMPLE 19 | 0.02 | 0.02 | 0.02 | 0.02 | 0.92 | -59 | 102 | 127 | 118 | 8% |
| EXAMPLE 20 | 0.04 | 0.04 | 0.04 | 0.04 | 0.84 | -59 | 102 | 128 | 122 | 5% |
| EXAMPLE 21 | 0.06 | 0.06 | 0.06 | 0.06 | 0.76 | -59 | 102 | 130 | 127 | 2% |
| EXAMPLE 22 | 0.08 | 0.08 | 0.08 | 0.08 | 0.68 | -59 | 102 | 135 | 130 | 3% |
| EXAMPLE 23 | 0.1 | 0.1 | 0.1 | 0.1 | 0.6 | -59 | 102 | 139 | 132 | 5% |
| EXAMPLE 24 | 0.12 | 0.12 | 0.12 | 0.12 | 0.52 | -59 | 102 | 144 | 133 | 8% |
| EXAMPLE 25 | 0.14 | 0.14 | 0.14 | 0.14 | 0.44 | -59 | 102 | 149 | 134 | 10% |
| EXAMPLE 26 | 0.16 | 0.16 | 0.16 | 0.16 | 0.36 | -59 | 102 | 154 | 136 | 12% |
| COMPARATIVE EXAMPLE 1 | 0 | 0 | 0 | 0 | 1 | -59 | -59 | 126 | 113 | 10% |
| COMPARATIVE EXAMPLE 2 | 0 | 1 | 0 | 0 | 0 | 74 | 74 | 195 | 143 | 27% |

### Examples 27 to 29

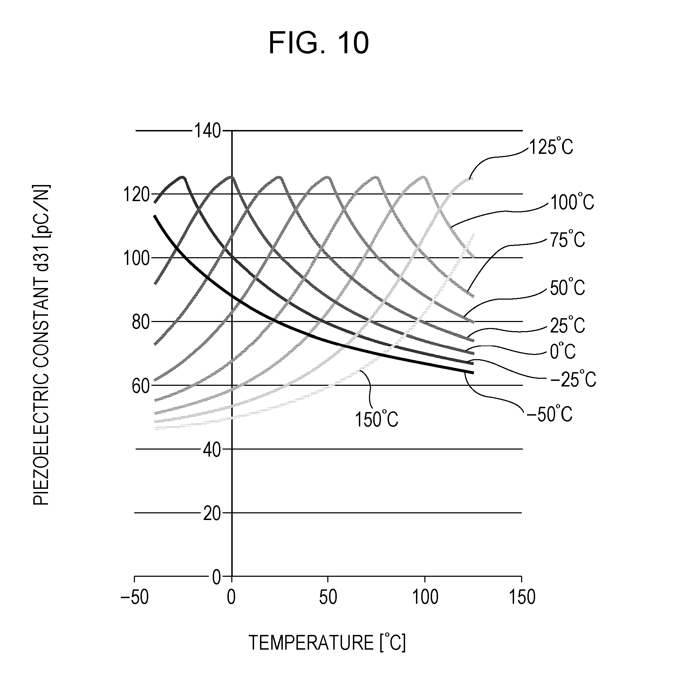

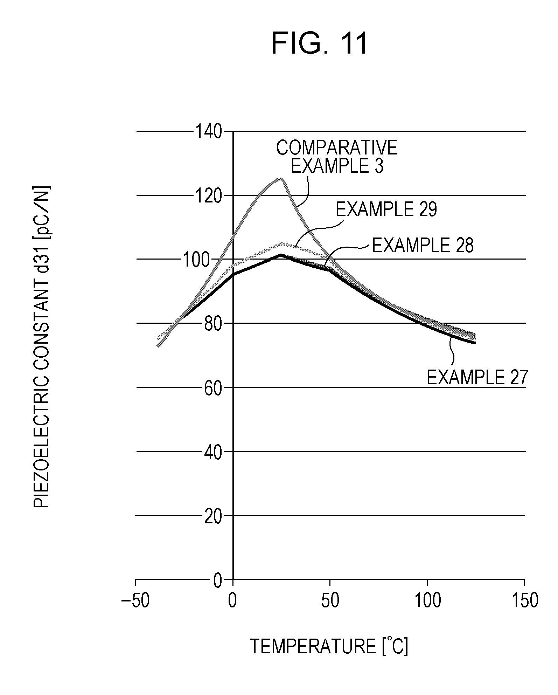

By assuming a series of piezoelectric materials which have the same maximum value of piezoelectric properties in the MPB and in which piezoelectric properties horizontally shift corresponding to the MPB, temperature dependence of piezoelectric properties in each composition (MPB temperature) are shown in Fig. 11. In Fig. 10, compositions 1 to 9 are shown by each MPB temperature.

Since the present material system is used in the use temperature range from -40°C to 125°C, each composition is realized at a ratio shown in Table 3, thereby forming the piezoelectric layer.

As Examples 27 to 29, lamination is performed so that the thickness of each composition is a ratio in Table 3, thereby forming the piezoelectric element. At this time, a layer of each composition may be one layer, or may be separated into a plurality of layers and a sum of thicknesses of these layers may be set to be a ratio in Table 3.

In addition, one of the single compositions whose piezoelectric properties are largest is regarded as a piezoelectric element in Comparative Example 3.

A minimum temperature T3 and a maximum temperature T4 of a MPB line in each of Examples 27 to 29, a maximum value and a minimum value in the use temperature range of the piezoelectric constant d31, and a variation range are shown in Table 3, and temperature dependence of the piezoelectric constant d31 is shown in Fig. 11.

As shown in Table 3, a piezoelectric element in Example 27 satisfies a relationship of both T3≤T1≤T4 and T3≤T2≤T4. Example 28 satisfies a relationship of T3≤T1≤T4, but does not satisfy a relationship of T3≤T2≤T4. A piezoelectric element in Example 29 does not satisfy a relationship of T3≤T1≤T4, but satisfies a relationship of T3≤T2≤T4. The Comparative Example 3 does not satisfy relationships of either T3≤T1≤T4 or T3≤T2≤T4.

As shown in Fig. 11, piezoelectric properties in the use temperature range from -40°C to 125°C in each embodiment have a larger minimum value of a piezoelectric constant, and smaller temperature variation than in Comparative Example 3, and thereby effects of the invention are proved.

**Table 3**

| COMPOSITION | 1 | 2 | 3 | 4 | 5 | 6 | 7 | 8 | 9 | T3 | T4 | PIEZOELECTRIC CONSTANT d31[pC/N] | | |
|---|---|---|---|---|---|---|---|---|---|---|---|---|---|---|
| MPB | -50°C | -25°C | 0°C | 25°C | 50°C | 75°C | 100°C | 125°C | 150°C | °C | °C | Max | Min | Range |
| EXAMPLE 27 | 0.07 | 0.07 | 0.26 | 0.26 | 0.26 | 0.02 | 0.02 | 0.02 | 0.02 | -50 | 150 | 101 | 75 | 25% |
| EXAMPLE 28 | 0.06 | 0.06 | 0.26 | 0.26 | 0.26 | 0.03 | 0.03 | 0.03 | 0 | -50 | 125 | 101 | 75 | 26% |
| EXAMPLE 29 | 0 | 0.07 | 0.29 | 0.29 | 0.29 | 0.01 | 0.01 | 0.01 | 0.01 | -25 | 150 | 105 | 75 | 28% |
| COMPARATIVE EXAMPLE 3 | 0 | 0 | 0 | 1 | 0 | 0 | 0 | 0 | 0 | 25 | 25 | 125 | 73 | 42% |

### Examples 30 to 32

Since the material system the same as in Examples 27 to 29 is used in the use temperature range from -40°C to 125°C, each composition is realized at a ratio shown in Table 4, thereby forming the piezoelectric layer.

As Examples 30 to 32, each composition is realized at a ratio in Table 4, thereby forming the piezoelectric element in a surface of the piezoelectric layer. At this time, a component of each composition may be in a single unit, or may be separated into a plurality of units and a sum of these areas may be set to be a ratio of Table 4.

Moreover, one of the single compositions whose piezoelectric properties are largest is regarded as a piezoelectric element in Comparative Example 3.

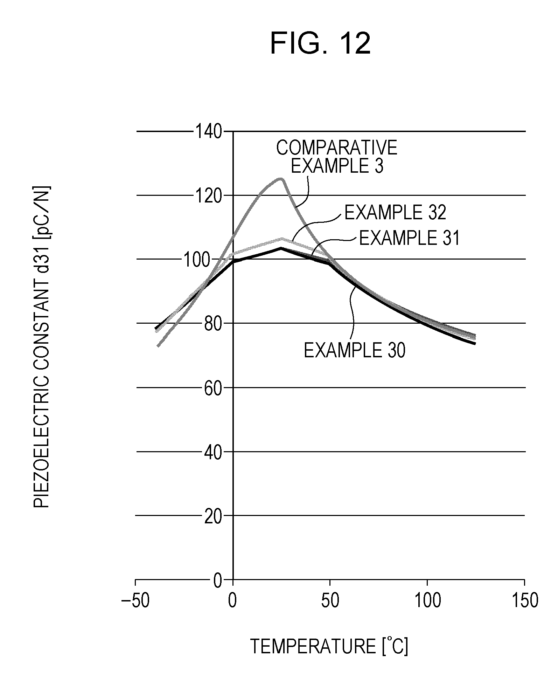

A minimum temperature T3 and a maximum temperature T4 of a MPB line in each of Examples 30 to 32, a maximum value and a minimum value in the use temperature range of the piezoelectric constant d31, and a variation range are shown in Table 4, and temperature dependence of the piezoelectric constant d31 is shown in Fig. 12.

As shown in Table 4, a piezoelectric element in Examples 30 satisfies a relationship of both T3≤T1≤T4 and T3≤T2≤T4. Example 31 satisfies a relationship of T3≤T1≤T4, but does not satisfy a relationship of T3≤T2≤T4. Example 32 does not satisfy a relationship of T3≤T1≤T4, but satisfies a relationship of T3≤T2≤T4. Comparative Example 3 does not satisfy relationships of either T3≤T1≤T4 or T3≤T2≤T4.

As shown in Fig. 12, piezoelectric properties in the use temperature range from -40°C to 125°C in each embodiment have a larger minimum value of a piezoelectric constant, and smaller temperature variation than in Comparative Example 3, and thereby effects of the invention are proved.

**Table 4**

| COMPOSITION | 1 | 2 | 3 | 4 | 5 | 6 | 7 | 8 | 9 | T3 | T4 | PIEZOELECTRIC CONSTANT d31[pC/N] | | |
|---|---|---|---|---|---|---|---|---|---|---|---|---|---|---|
| MPB | -50°C | -25°C | 0°C | 25°C | 50°C | 75°C | 100°C | 125°C | 150°C | °C | °C | Max | Min | Range |
| EXAMPLE 30 | 0.07 | 0.07 | 0.26 | 0.26 | 0.26 | 0.02 | 0.02 | 0.02 | 0.02 | -50 | 150 | 101 | 75 | 25% |
| EXAMPLE 31 | 0.06 | 0.06 | 0.26 | 0.26 | 0.26 | 0.03 | 0.03 | 0.03 | 0 | -50 | 125 | 101 | 75 | 26% |
| EXAMPLE 32 | 0 | 0.07 | 0.29 | 0.29 | 0.29 | 0.01 | 0.01 | 0.01 | 0.01 | -25 | 150 | 105 | 75 | 28% |
| COMPARATIVE EXAMPLE 3 | 0 | 0 | 0 | 1 | 0 | 0 | 0 | 0 | 0 | 25 | 25 | 125 | 73 | 42% |

### Other Embodiments

As described above, embodiments of the invention are described; however, a basic configuration of the invention is not limited to embodiments described above. For example, in the embodiments, a silicon single crystal substrate is exemplified as the flow path forming substrate 10; however, the flow path forming substrate is not particularly limited thereto, and may be set to use a material such as an SOI substrate, glass, and the like.

Furthermore, in the embodiments, the piezoelectric element 300 which sequentially laminates the first electrode 60, the piezoelectric layer 70, and the second electrode 80 on a substrate (flow path forming substrate 10) is exemplified; however, the invention is not particularly limited thereto. It is possible to apply the invention to a piezoelectric element of a vertical oscillation type which alternately laminates, for example, a piezoelectric material and an electrode forming material to be expanded or contracted in an axis direction.

In the embodiments, an ink jet recording head is described as an example of a liquid ejecting head; however, the invention is widely intended for the entirety of liquid ejecting heads, and can also be applied to a liquid ejecting head which ejects liquid in addition to an ink. As the other liquid ejecting heads, various types of recording heads which are used in image recording devices such as printers, and the like, a color material ejecting head which is used in manufacturing color filters such as a liquid crystal display and the like, an electrode material ejecting head which is used in forming electrodes such as an organic EL display, a field emission display (FED) or the like, a bio-organic material ejecting head which is used in manufacturing a bio-chip, and the like are exemplified.

The piezoelectric element of the invention shows a good insulation property and good piezoelectric properties, such that it is possible to apply the invention to a piezoelectric element of a liquid ejecting head represented by an ink jet recording head as described above; however, the invention is not limited thereto. It is possible to apply the invention to, for example, a piezoelectric element of an ultrasonic device like an ultrasonic transmitter and the like, an ultrasonic motor, a piezoelectric transformer, and various types of sensors such as an infrared sensor, an ultrasonic sensor, a thermal sensor, a pressure sensor, a pyroelectric sensor, and the like. In addition, the invention can be similarly applied to ferroelectric elements such as a ferroelectric memory and the like.

The value of the lowest use temperature T1 (-40 °C) and the value of the highest use temperature T2 (125 °C) exemplified in the embodiment are examples, and other values may also be applied. The value of T1 and the value of T2 are determined depending on the usage, the use environment, the required performance, and the like of the piezoelectric element. In other words, the value of T1 and the value of T2 are determined from a viewpoint of the temperature range in which an operation of the piezoelectric element is ensured. The temperature range in which an operation of the piezoelectric element is ensured varies depending on the usage, the use environment, the required performance, and the like of the piezoelectric element.

For example, the temperature range in which an operation of the piezoelectric element is ensured is from 5°C to 40°C, in a case where the piezoelectric element is used in a liquid ejecting apparatus; is from -25°C to 85°C, in a case where the piezoelectric element is used in a ceramic capacitor, even if it varies depending on the usage of the capacitor; is from 0°C to 70°C, in a case where the piezoelectric element is used in a vehicle sensor; and is from -10°C to 50°C, in a case where the piezoelectric element is used in an ultrasonic sensor for examination of a human body.

Regardless of whether a difference between T1 and T2 is small or great, when formulas T3≤T1≤T4 and T3≤T2≤T4 are satisfied, temperature dependence of piezoelectric properties in the temperature range of T1 to T2 is substantially reliably reduced, and thus stability of operation in the temperature range is substantially reliably ensured.

In addition, in a case where a difference between T1 and T2 is great, when formulas T3≤T1≤T4 and T3≤T2≤T4 are satisfied, it is possible to obtain a high performance piezoelectric element having a more reduced temperature dependence and more excellent in stability of operation.

As previously described, it is not necessarily required that both of formulas T3≤T1≤T4 and T3≤T2≤T4 are satisfied. As long as any one of the formulas is satisfied, it is possible to reduce the temperature dependence of piezoelectric properties.

The foregoing description has been given by way of example only and it will be appreciated by a person skilled in the art that modifications can be made without departing from the scope of the present invention.

## Claims

1. A piezoelectric element (300) to be used between a lowest use temperature T1 and a highest use temperature T2, comprising:
a first electrode;
a piezoelectric layer (70) provided on the first electrode and made of a piezoelectric material including a composite oxide having a perovskite structure; and
a second electrode provided (80) on the piezoelectric layer,
wherein the piezoelectric material includes a morphotropic phase boundary which is inclined with respect to a temperature axis, and satisfies at least one of formulas T3≤T1≤T4 and T3≤T2≤T4, where a temperature corresponding to the morphotropic phase boundary is T3 at a lowest point, and is T4 at a highest point.

2. The piezoelectric element according to claim 1, wherein the piezoelectric material includes at least two types of composite oxides having a perovskite structure.

3. The piezoelectric element according to claim 2, wherein the piezoelectric layer is obtained by laminating a plurality of piezoelectric materials in which the ratio of constituent elements is different each other, or by distributing the plurality of piezoelectric materials in which the ratio of constituent elements is different each other in an in-plane direction.

4. The piezoelectric element according to claim 2, wherein the piezoelectric layer is obtained by laminating a plurality of piezoelectric materials in which at least one of two types or more of composite oxides is different each other, or by distributing the plurality of piezoelectric materials in which at least one of two types or more of composite oxides is different each other in an in-plane direction.

5. The piezoelectric element according to any one of the preceding claims, wherein, when the perovskite structure is expressed by ABO₃, A site includes at least one of Pb, Ba, Sr, Ca, Li, K, Na, and Bi, and B site includes at least one of Zr, Ti, Nb, Ta, Fe, Mn, and Co.

6. The piezoelectric element according to any one of the preceding claims, wherein the composite oxide includes a combination of any of KNbO₃-NaNbO₃, KNb₃-KTaO₃, PbZrO₃-PbTi₃, (Bi_{1/2}K_{1/2})TiO₃-(Bi_{1/2}Na_{1/2})TiO₃, (Bi_{1/2}K_{1/2})TiO₃-BaTiO₃, (Bi_{1/2}NA_{1/2})TiO₃-BaTiO₃, BiFeO₃-BiCoO₃.

7. The piezoelectric element according to any one of claims 1 to 5, wherein the composite oxide is a mixed crystal of (K, Na)NbO₃ and Li(Nb, Ta)O₃.

8. A liquid ejecting head comprising the piezoelectric element according to any one of the preceding claims.

9. A liquid ejecting apparatus comprising the liquid ejecting head according to claim 8.

10. An actuator comprising the piezoelectric element according to any one of claims 1 to 7.

11. A sensor comprising the piezoelectric element according to any one of claims 1 to 7.

12. A motor comprising the piezoelectric element according to any one of claims 1 to 7.
